Europäisches Patentamt

**European Patent Office**

Office européen des brevets

(19)

(11) Publication number: **0 099 725**

**A2**

(12) **EUROPEAN PATENT APPLICATION**

(21) Application number: **83304067.8**

(22) Date of filing: **13.07.83**

(51) Int. Cl.³: **C 23 C 13/08**

(30) Priority: **14.07.82 US 398151**

(43) Date of publication of application:
**01.02.84 Bulletin 84/5**

(84) Designated Contracting States:
**BE CH DE FR GB IT LI LU NL SE**

(71) Applicant: **THE STANDARD OIL COMPANY**
**Midland Building**
**Cleveland, Ohio 44115(US)**

(72) Inventor: **Vukanovic, Vladimir**
**66 Westland Avenue**
**Rochester New York 14618(US)**

(74) Representative: **Smith, Sydney et al,**
**Elkington and Fife High Holborn House 52/54 High**
**Holborn**
**London WC1V 6SH(GB)**

(54) **High pressure, non-local thermal equilibrium arc plasma generating apparatus for deposition of coatings upon substrates.**

(57) An apparatus for generating an arc plasma in a non-local thermal equilibrium and an apparatus for the deposition of a material upon a substrate comprising the above are disclosed.

Referring to the accompanying illustrative drawing, a closed chamber (25) is defined by a cylindrical anode (11) and annular housings (21, 22) carrying transparent end plates (23, 24). A pencil-shaped cathode (12) is passed through one end plate (23) coaxially into chamber (25) so that its tapered end (20) is spatially proximate to an exit orifice (44) centrally located in anode (11). Gas ports (30, 31) permit the introduction of a preselected gaseous environment at the desired pressure into chamber (25). A low-current arc is struck between anode (11) and cathode (12) establishing the desired plasma. Two coils (33, 34) are coaxially placed radially outward of both ends of the chamber in a Hemholtz coil configuration to generate a uniform magnetic field in chamber (25) and induce rotation of the arc plasma. The coating material is introduced into the plasma as by a reservoir (40) in cathode (12) and its excited species ejected through exit orifice (44) in a plasma jet for deposition upon substrate adjacent thereto.

The apparatus generates a non-local thermal equilibrium arc plasma at the relatively high pressure of at least 1 atmosphere.

The present invention provides advantages over the prior art.

FIG. 3

"High Pressure, Non-local Thermal Equilibrium Arc Plasma
Generating Apparatus for Deposition of Coatings Upon
Substrates"

This invention relates to high pressure, non-local
thermal equilibrium arc plasma  generating apparatus for
deposition of coatings upon substrates; more particularly,
it relates to such an apparatus for deposition of coatings
at pressures from 0.1 to 3  atmospheres.

Various applications require the deposition of thin,
smooth and uniform coatings on substrates.  Where the
application necessitates deposition on all sides of the
substrate, it has been found desirable to place the
substrate in a thermionic emission of the coating material
induced by magnetron sputtering or plasma spraying.
Substrates, such as microballoons, have been coated using
low pressure plasma sources by bouncing the substrates or
by gas jet levitation.  However, if the targets are
bounced during the deposition process, the coating may be
damaged or the targets may tend to adhere to the bouncing
plate or to each other due to either electrostatic
interactions or cold welding.  Levitation processes using
gas jets during the coating process are hampered due to
the electrostatic interaction between the target and the
levitator, while the low pressure required for sputtering
hampers the levitation process.

Plasma coating processes heretofore have also been
carried out at similar low pressures principally because
it is under these conditions that a plasma is not
influenced by local thermal equilibrium (hereinafter
referred to as "LTE") conditions.  A plasma exhibiting
non-LTE contains many heavy species (e.g. atomic free
radical and excited molecular, in ground, ionised or
or excited states) of the coating material at temperatures
lower than the electron temperatures, significantly
facilitating the carriage of the coating material in the plasma to the substrate and rendering unnecessary periodic quenching of the plasma. Unfortunately, at the low pressures conducive to non-LTE conditions, it is often difficult to levitate substrates and the rate of deposition and yield are unacceptably low.

Increasing the plasma operating pressure to the relatively high pressure of at least 0.1 atmosphere may result in a more extensive LTE influence, depending upon arc current utilised, as well as species in the plasma (low ionisation or molecular species). Although levitation of substrates is easier and deposition rate, yield and heat conductivity are all greater under these conditions, few, if any, atomic and free radical species of the coating material exist in the plasma, deleteriously affecting the carriage of the coating material to the substrate. Accordingly, existing plasma deposition apparatus has been designed to operate at pressures of only thousandths of an atmosphere to foster non-LTE conditions. Additionally, high pressure plasma deposition apparatus almost universally has been in the form of a "spray gun" often with a complex combination of multiple chambers.

In recent years, a type of arc plasma source radically different in structure than that previously employed as sources for plasma depositions has been developed for use as light source in spectroscopy. This source provides a horizontal or vertical rotating arc burning in a graphite tube in air immersed within a magnetic field to increase the residence time of particles in the plasma, for better analysis. It has now been found that a modified form of this source may be utilised to establish and maintain a non-LTE plasma at the relatively high pressures noted above and facilitate the deposition of substrates with coatings.

It is an object of the present invention to provide an apparatus for generating an arc plasma in non-local thermal equilibrium at relatively high pressure suitable for deposition of coatings upon substrates.

It is another object of the present invention to provide an apparatus for generating an arc plasma, as above, in which substrates may be levitated to facilitate uniform coating.

It is yet another object of the present invention to provide an apparatus for generating an arc plasma, as above, in which the deposition rate is fast and controllable.

It is a further object of the present invention to provide an apparatus for generating an arc plasma, as above, in which heavy species of the coating material exist at temperatures lower than the electron temperature, significantly facilitating the carriage of the coating material in the plasma to the substrate and rendering unnecessary periodic quenching of the plasma.

It is still another object of the present invention to provide an apparatus for generating an arc plasma, as above, in which the plasma heat conductivity and concentration of activated species is greater and the mean free paths shorter than that occurring in a low pressure, non-LTE plasma.

In general, an apparatus for deposition of materials upon a substrate embodying the concept of the present invention includes means for generating a non-local thermal equilibrium arc plasma, means for establishing a magnetic field in the region of the means for generating an arc plasma to induce motion of the arc plasma and means for establishing in this region a preselected gaseous environment at a pressure of at least 0.1 atmosphere. The means for generating an arc plasma includes a first electrode and a second electrode proximate thereto both for establishing field conditions in which the arc plasma may exist, the aforesaid region being between these electrodes, and further including means for generating an electrical current of at least 0.5 amperes, preferably from 2 to 10 amperes, between these electrodes so as to maintain non-local thermal equilibrium.

In one embodiment, the present invention provides an apparatus for generating an arc plasma in a non-local thermal equilibrium characterised in that it comprises: first electrode means for establishing field conditions in which the arc plasma may exist; second electrode means for establishing field conditions in which the arc plasma may exist, the second electrode means proximate the first electrode means; means for establishing a magnetic field in the region of the first electrode means and the second electrode means to induce motion of the arc plasma; means for establishing and maintaining at least in a region between the first electrode means and the second electrode means a preselected gaseous environment at a pressure of at least 0.1 atmosphere; and means for generating an electrical current of at least 0.5 amperes between the first electrode means and the second electrode means so as to maintain non-local thermal equilibrium conditions in the arc plasma.

In another embodiment, the present invention provides an apparatus for the deposition of a material upon a substrate characterised in that it comprises: means for generating an arc plasma in a non-local thermal equilibrium comprising first electrode means for establishing field conditions in which the arc plasma may exist and second electrode means for establishing field conditions in which the arc plasma may exist, the second electrode means proximate first electrode means; means for establishing a magnetic field in the region of the first electrode means and the second electrode means to induce motion of the arc plasma; means for establishing and maintaining at least in a region between the first electrode means and the second electrode means a preselected gaseous environment at a pressure of at least
0.1 atmosphere; and means for generating an electrical
current of at least 0.5 amperes between the first
electrode means and the second electrode means so as
to maintain non-local thermal equilibrium conditions in
the arc plasma.

Referring to the accompanying drawings:

Fig. 1 is a front elevational view of an exemplary
apparatus in accordance with the present invention
having a cathode feed reservoir for the introduction
of the deposition material into the plasma (seen in
Fig. 3), and an exit orifice to effect deposition external
to the anode in a plasma jet.

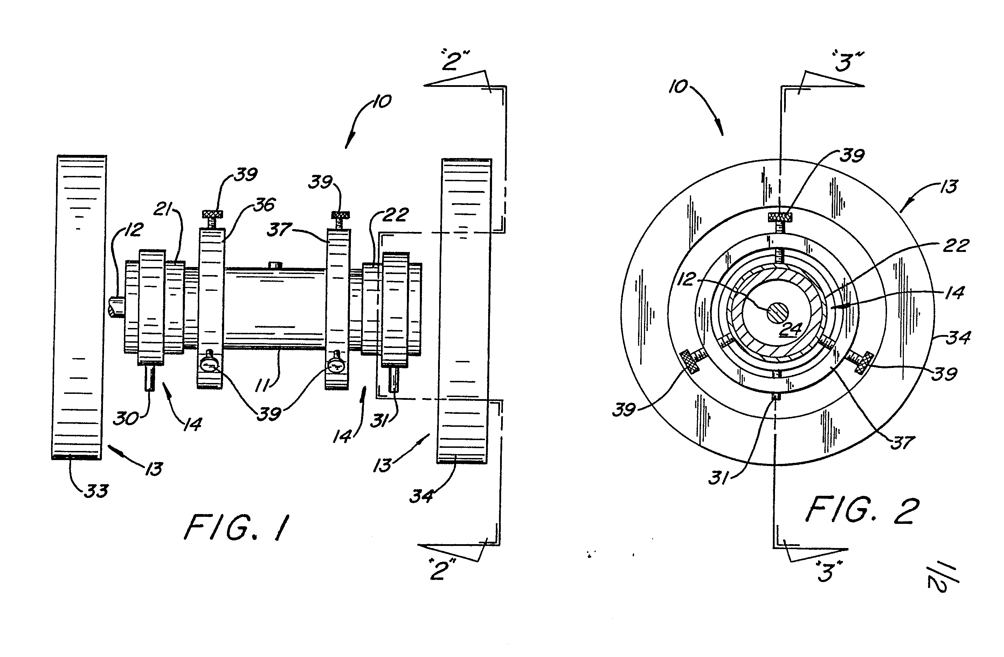

Fig. 2 is a side elevational view of the
apparatus illustrated in Fig. 1 taken substantially along
line 2-2 of Fig. 1.

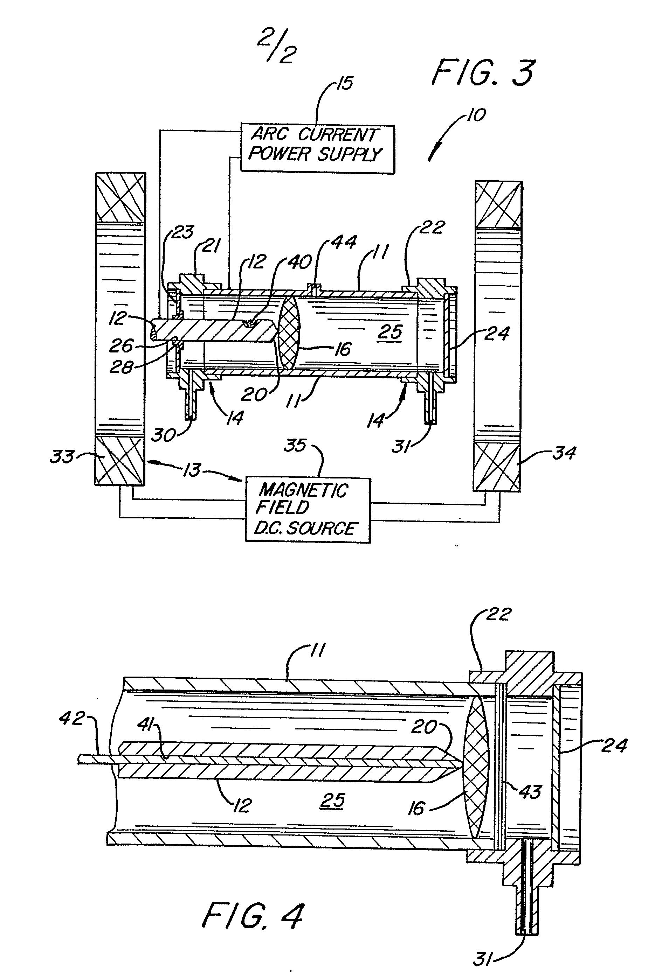

Fig. 3 is a vertical cross-sectional view of the
apparatus illustrated in Figs. 1 and 2 taken substantially
along line 3-3 of Fig. 2.

Fig. 4 is a side elevational view of an alternative
apparatus in accordance with the present invention having
a continuous feed mechanism for the introduction of the
deposition material into the plasma and a deposition
substrate surface internal to the anode in the region of
the plasma arc.

Figs. 1,2 and 3 illustrate an apparatus, generally
indicated by the numeral 10, for the deposition of
materials upon substrates by means of an arc generated
plasma operating under high pressure and non-local thermal
equilibrium (hereinafter referred to as "non-LTE")
conditions. Apparatus 10 broadly includes anode 11,
cathode 12, magnetic field generator 13, environmental
control 14 and arc current power supply 15.

Anode 11 is a cylindrically-shaped hollow electrode,
preferably formed of a suitable conductive material, such
as graphite or tungsten, capable of withstanding the current and temperature conditions as are known to occur in generating an arc plasma. Cathode 12 is a cylindrically-shaped electrode, smaller in diameter than anode 11 and tapered at one end 20, also preferably formed of a suitable conductive material similar to that of anode 11, most preferably of graphite. The tapered end 20 of cathode 12 is extended coaxially within anode 11 by an appropriate mechanism, such as that described below. In this configuration, impression of the necessary voltage and current explained below between anode 11 and cathode 12 will result in an arc being struck between tapered end 20 of cathode 12 and the inner periphery of anode 11 radially closest thereto.

Environmental control 14 permits selected control of the environment between anode 11 and cathode 12 necessary for the maintenance of high pressure, non-LTE conditions in the arc plasma and furnishes a vehicle by which the deposition material may be introduced into the arc plasma. Environmental control 14 includes two annular end plate housings 21, 22, into which the ends of anode 11 are inserted, and two end plates 23, 24 carried in housings 21, 22, respectively, all of which, together with anode 11, define a closed, hermetically sealed chamber 25 interior to anode 11. Of course, housings 21, 22 and end plates 23, 24 must be selected of material, such as ceramic, capable of withstanding the extreme temperatures (typically up to several thousand degrees centigrade) generated during operation of apparatus 10. Additionally, it may be useful to permit direct visual observation of the arc plasma during operation. Housings 21, 22 made of ceramics, such as "Lava" material available from 3M Company, South Carolina, U.S.A., and end plates 23, 24 made of sapphire have been found to meet the necessary temperature constraints and permit relatively distortion free viewing of the arc plasma.

Cathode 12 may pass through a bore 26 in either end plate 23, 24 (for illustration purposes cathode 12 is shown passing through end plate 23) and a gasket 28 interposed between bore 26 and cathode 12 more readily to provide axial support to cathode 12 and maintain chamber 25 hermetically sealed from the ambient environment. Gas ports 30, 31 are bored in housings 21, 22, respectively, in order to introduce, exhaust and maintain a preselected gaseous environment at a preselected pressure within chamber 25.

Deposition of materials carried as atomic species within an arc plasma may be greatly facilitated where the arc plasma is caused to move and most preferably to rotate in a preselected spatial region. An arc struck and caused to rotate within apparatus 10 between tapered end 20 of cathode 12 and the inner periphery of anode 11 will generate a similarly rotating plasma region which, over time, would define and appear as a disc shaped region 16.

Rotation of the plasma arc may be induced by generation of a magnetic field having flux lines at right angles to all points along the circular perimeter of anode 11. One established technique for furnishing such a magnetic field is the use of a so-called Hemholtz coil arrangement in which two coils 33 and 34 of greater diameter than anode 11 are positioned in longitudinal axial alignment with anode 11 radially outward of both ends of chamber 25. Upon excitation by a suitable direct current source 35 the requisite stationary magnetic field is established with a highly uniform field magnitude and direction. Ring supports 36 and 37 having a plurality of individually adjustable set screws 39 may be provided for support of chamber 25 so that corrections may be made in the alignment of the magnetic field with that of chamber 25.

It should be understood that, although a Hemholtz coil configuration has been found to induce an acceptable magnetic field, apparatus 10 may employ another device or method which would furnish a field, either stationary or time-variant, that would induce the desired motion of the plasma region. Indeed, dependent upon the specific geometry utilised for material deposition and characteristics of the deposition material, motions other than circular may be preferred for different applications.

Arc current power supply 15 includes a low voltage (for example from 30 to 200 volts), low magnitude direct current (for example from 2 to 10 amperes) power source for electrical connection between anode 11 and cathode 12. The exact voltage and current necessary to maintain the arc plasma will be principally dependent upon the ionisation potential of the deposition material and the separation between anode 11 and cathode 12. However, as lower magnitude currents have been found to be most conducive to non-LTE conditions, it is preferable to utilise the minimum current magnitude necessary to excite the atomic species of the material of interest. For example, successful operation with graphite electrodes separated approximately 9 mm with argon as the carrier gas and zinc as the deposition material has been effected with as little as 2 amperes at 35 volts.

Arc current power supply 15 should be regulated in known manner as fluctuations in current magnitude may adversely affect arc plasma motion. Additionally, power supply 15 may incorporate a high voltage impulse generator, such as a Tesla coil, to furnish the potential required to cause initial breakdown of the gas introduced between anode 11 and cathode 12 and the striking of an arc therebetween.

Several techniques are available for introduction of the deposition material into the carrier gas in chamber 25. First, a reservoir 40 may be bored in cathode 12 a short distance behind its tapered end 20 and a powdered supply of the desired deposition material placed therein. During operation, cathode 12 in the vicinity of the reservoir reaches temperatures sufficient to vaporize the deposition material, which is carried into the arc plasma by the carrier gas and activated into states where its atomic species exist in the plasma, which species are then transported by the carrier gas to the deposition site. Although straightforward, the use of reservoir 40 requires periodic shutdown of apparatus 10 for replenishment of this finite material supply.

Instead of or in addition to the use of reservoir 40, as shown in Fig. 4, a small bore 41 may be made through the longitudinal axis of cathode 12 and the deposition material 42 continuously fed into chamber 25 therethrough. Here again temperatures in the vicinity of tapered end 20 would vaporize the deposition material 42 for introduction into the arc plasma.

Instead of or in addition to the use of reservoir 40 or small bore 41, the deposition material may be vaporized within chamber 25 by means for applying heat from an energy source, such as a laser, placed external to chamber 25. The laser beam utilised could pass through the sapphire end plates 23, 24, which end plates in another embodiment could also provide optical access for still or motion photographic equipment, including real-time video monitors.

The deposition material may be vaporized externally to apparatus 10 and injected into the carrier gas prior to its entrance into chamber 25. In this instance, however, it may be necessary to preheat the carrier gas and maintain it at an elevated temperature so that the vaporized deposition material does not condense prior to introduction into the arc plasma.

Deposition may take place in a region either within chamber 25 as best illustrated in Fig. 4, or externally to chamber 25 as illustrated in Figs. 1 and 3. When depositions are to be made within chamber 25, a substrate 43 may be interposed between the end of anode 11 and the housing 22, opposite the end plate 23, through which cathode 12 enters chamber 25. In this instance, cathode 12 is extended within chamber 25 until arc plasma region 16 is either adjacent or in spaced apart relation to target substrate 43.

Deposition external of chamber 25 may be effected by inclusion of an exit orifice 44 within anode 11. Inasmuch as the periphery of the arc has been found to contain the greatest concentration of species in non-LTE conditions, appropriate alignment of arc plasma region 16 in slight offset proximity to exit orifice 44 will result in a jet stream of plasma exiting chamber 25 therethrough, permitting the most efficient deposition upon substrate positioned within the jet stream of plasma.

Microspheroidal substrates such as glass microballoons, may be removeably mounted within chamber 25 by utilisation of a mounting stalk communicating through a suitable opening in chamber 25. In addition, for complete and uniform deposition of the coating material, such substrates may be positioned within chamber 25 or levitated by means of a gas suspension jet or a laser beam (not shown) entering chamber 25.

Multiple arc plasma regions, useful for establishing a greater concentration of species of the deposition material in the substrate area, may be established by the insertion of additional cathodes into chamber 25. Merely by way of example, a second cathode (not shown) may be inserted into chamber 25 as illustrated in Figs. 1 and 3 through end plate 24 in the same manner as that of cathode 12.

Apparatus 10 operates to generate arc plasmas in relatively high pressure (for example from 0.1 to 3 atmospheres) and exhibiting non-LTE conditions preferable for the deposition of various materials on a variety of substrates, such as quartz, glass or metal. With regard to the embodiment most favourably illustrated in Fig. 3, in preparation for operation, a supply of the deposition material, including silicon, metals, semiconductor dopant or component elements and particularly metals having a moderate to high ionisation potential, are placed in powdered form in reservoir 40 and cathode 12 placed in chamber 25 so that its tapered end 20 is proximate exit orifice 44. A carrier gas, preferably of an inert element, such as argon, is passed through chamber 25 via gas ports 30 and 31, thereby purging chamber 25 of other gases.

Active operation is begun by the energisation of coils 33 and 34 with power furnished by direct current source 35 so as to establish the magnetic field by which rotation of the plasma region is induced. Next, the Tesla coil in arc current power supply 15 generates a high voltage impulse resulting in an arc being struck between tapered end 20 of cathode 12 and the inner periphery of the anode radially closest thereto. Contemporaneously therewith, arc current power supply 15 impresses across anode 11 and cathode 12 the low voltage, direct current sufficient to maintain the established arc in the preselected gaseous carrier. The plasma produced by the arc reaches temperatures of several thousand degress centigrade. The heat produced by the arc is conducted to the cathode, vaporizing the metal or other deposition material for transport into the arc plasma for activation into states where its species exist in the plasma. The carrier gas further transports these species out exit orifice 44 where anything in that vicinity (such as glass microballoon targets as used in nuclear fusion reactions) may be uniformly coated with metal at thickness of from less than one micron (micrometre) to several microns. As previously noted, the substrate to be coated would be mounted within anode 11, and cathode 12 appropriately positioned such that the species strike the substrate.

CLAIMS

1.      An apparatus for generating an arc plasma in a
non-local thermal equilibrium characterised in that it
comprises: first electrode means for establishing field
conditions in which the arc plasma may exist; second
electrode means for establishing field conditions in which
the arc plasma may exist, the second electrode means
proximate the first electrode means; means for
establishing a magnetic field in the region of the first
electrode means and the second electrode means to induce
motion of the arc plasma; means for establishing and
maintaining at least in a region between the first
electrode means and the second electrode means a
preselected gaseous environment at a pressure of at least
0.1 atmosphere; and means for generating an electrical
current of at least 0.5 amperes between the first
electrode means and the second electrode means so as to
maintain non-local thermal equilibrium conditions in the
arc plasma.

2.      An apparatus for the deposition of a material
upon a substrate characterised in that it comprises:
means for generating an arc plasma in a non-local thermal
equilibrium comprising first electrode means for
establishing field conditions in which the arc plasma may
exist and second electrode means for establishing field
conditions in which the arc plasma may exist, the second
electrode means proximate first electrode means; means
for establishing a magnetic field in the region of the
first electrode means and the second electrode means to
induce motion of the arc  plasma; means for establishing
and maintaining at least in a region between the first
electrode means and the second electrode means a
preselected gaseous environment at a pressure of at least
0.1 atmosphere; and means for generating an electrical current of at least 0.5 amperes between the first electrode means and the second electrode means so as to maintain non-local thermal equilibrium conditions in the arc plasma.

3.    An apparatus as claimed in claim 1 or claim 2 wherein the means for establishing and maintaining a preselected gaseous environment establishes and maintains pressure of from 0.1 to 3 atmospheres.

4.    An apparatus as claimed in any of claims 1 to 3 wherein the means for establishing and maintaining a preselected gaseous environment comprises sealed chamber means within which the arc plasma is struck and maintained.

5.    An apparatus as claimed in any of claims 1 to 4 wherein the first electrode is a cylindrically shaped hollow anode, the chamber means defined by the anode and comprising end plate means for sealing the ends of the anode and housing means for mounting of the end plate means to the anode.

6.    An apparatus as claimed in claim 5 wherein the housing means comprises port means communicating with the chamber means for the passage of a preselected gaseous environment into the chamber means.

7.    An apparatus as claimed in claim 5 or claim 6 wherein the housing means comprises orifice means in the chamber means for permitting passage of a jet of the arc plasma exterior to the chamber means.

8.    An apparatus as claimed in claim 7 wherein the orifice means is positioned proximate the periphery of the arc plasma.

2

9.    An apparatus as claimed in any of claims 1 to 8 wherein the second electrode means is a cathode extending into the chamber means and tapered at the end thereof so extended into the chamber means.

10.    An apparatus as claimed in claim 9 wherein the cathode is substantially pencil-shaped and has its tapered end coaxially inserted through the end plate means into the chamber means.

11.    An apparatus as claimed in claim 9 or claim 10 wherein the cathode is formed of graphite.

12.    An apparatus as claimed in any of claims 1 to 11 wherein the means for establishing a magnetic field comprises coil means for generating a uniform magnetic field whose principal longitudinal flux axis is aligned with the longitudinal axis of the first electrode means.

13.    An apparatus as claimed in claim 12 wherein the coil means generates a stationary magnetic field having flux lines at right angles to all points along the perimeter of the first electrode means, whereby rotation of the arc plasma within the chamber means is induced.

14.    An apparatus as claimed in claim 12 or claim 13 wherein the first electrode means is a cylindrically-shaped hollow anode and the coil means comprises a first toroidal coil and a second toroidal coil positioned in longitudinal axial alignment with the anode radially outward of the ends of the anode.

15.    An apparatus as claimed in any of claims 1 to 14 wherein the anode is formed of graphite.

16.    An apparatus as claimed in claim 14 wherein the means for establishing a magnetic field further comprises a direct current source furnishing electrical power to first coil and the second coil.

17. An apparatus as claimed in any of claims 1 to 16 wherein the means for establishing a magnetic field includes means for generating a time-variant magnetic field.

18. An apparatus as claimed in any of claims 1 to 17 wherein the means for generating a current is electrically connected to the first electrode means and the second electrode means and comprises means for generating a high voltage impulse to effect initial striking of an arc between the first electrode means and the second electrode means.

19. An apparatus as claimed in any of claims 2 to 18 further comprising means to introduce species of a material of interest into the arc plasma.

20. An apparatus as claimed in claim 19 wherein the means to introduce species comprises reservoir means bored into the second electrode means proximate to the region in the chamber means where the arc plasma exists, a quantity of the material of interest being placed within the reservoir.

21. An apparatus as claimed in claim 19 or claim 20 wherein the means to introduce species includes passageway means through the second electrode means for continuously passing the material of interest into the chamber means in the region where the arc plasma exists.

22. An apparatus as claimed in claim 19 wherein the means to introduce species comprises a quantity of the material of interest formed with the second electrode means.

23.     An apparatus as claimed in any of claims 2 to 22 further comprising means for directing at least a portion of the arc plasma toward a substrate upon which the material of interest may be deposited.

24.     An apparatus as claimed in claim 23 wherein the means for directing comprises orifice means in the chamber means for permitting the passage of a jet of the arc plasma toward the substrate exterior to the chamber means.

FIG. 1

FIG. 2

0099725

1/2

2/2

FIG. 3

ARC CURRENT
POWER SUPPLY

MAGNETIC
FIELD
D.C. SOURCE

FIG. 4